# EUROPÄISCHE PATENTSCHRIFT

(11) **EP 0 540 765 B1**
(45) Veröffentlichungstag und Bekanntmachung des Hinweises auf die Patenterteilung: **23.06.1993**
(21) Anmeldenummer: 91118364.8
(22) Anmeldetag: 28.10.1991
(51) Int. Cl.: G01R 21/00

(54) **Schaltung zur Netztakterzeugung**
Circuit generating a clock signal synchronised with the mains
Circuit générant un rythme de commande synchronisée avec le secteur

(43) Veröffentlichungstag der Anmeldung: 12.05.1993
(73) Patentinhaber: SIEMENS AKTIENGESELLSCHAFT, 80333 München (DE)
(72) Erfinder: Windsheimer, Klaus, Dipl.-Ing. (FH), W-8533 Scheinfeld (DE)

(56) Entgegenhaltungen:
- EP-A- 0 014 038
- EP-A- 0 373 248
- WO-A-83/03011
- DE-A- 2 834 881

## Beschreibung

Die Erfindung betrifft eine Schaltung zur Erzeugung eines aus der Netzfrequenz abgeleiteten Taktsignals für ein drehstrombetriebenes Gerät, bei der zwei Phasenspannungen eines angeschlossenen Drehstromsystems unverändert um 120° gegeneinander phasenverschoben sind und die dritte Phasenspannung gegenüber ihrer ursprünglichen Phasenlage um 180° gedreht ist und bei der das Taktsignal am Ausgang eines Summierers abgreifbar ist.

Schaltungen dieser Art sind für Meßgeräte bekannt (siehe DE-A-28 34 881), die als Zeitbasis die Netzfrequenz als Referenz benutzen. Durch die Phasendrehung der einen Phasenspannung wird die Strom- bzw. Spannungssumme abweichend von Null, so daß auch bei Ausfall einer oder mehrerer Phasen ein aus der Netzfrequenz abgeleitetes Taktsignal (Netztaktsignal) abgeleitet werden kann. In der praktischen Ausführung wird hier einer Phase ein Phasenschieber zugeordnet. Die Strom- und Spannungssignale aus jeder Phase, d.h. auch der gedrehten Phase, werden einem Summierer zugeführt. Am Ausgang des Summierers ist eine Referenz vorhanden, solange eine Phase strom- und spannungsführend ist. Nicht nur der Einsatz eines Phasenschiebers, sondern auch der Betrieb direkt mit der Phasenleiterspannung des Energieverteilungsnetzes bringt erhöhten Aufwand für Maßnahmen hinsichtlich Isolationsfestigkeit und Gefährdungssicherheit mit sich. Weiterhin ist aus der EP-A-0 373 248 eine Drehstromschaltungsanordnung für die netzsynchrone Zeitsteuerung eines elektrischen Gerätes bekannt. Hier werden die Netztaktimpulse aus einer Steuerspannung gebildet, die zwischen einem durch drei ungleich große Widerstände gebildeten Sternpunkt und dem Nulleiter bzw. einem weiteren, aus Widerständen gebildeten Sternpunkt abgenommen wird. Der Betrieb dieser Anordnung erfolgt auch hier direkt mit den Phasenleiterspannungen ohne Zwischenschaltung von Übertragern. Es werden bei Bildung zweier Sternpunkte sechs spannungsfeste Widerstände benötigt. Wegen Fehlens von Übertragern liegt keine galvanische Trennung der Schaltungsanordnung vor.

Die Verwendung von Übertragern, um galvanische Trennung von einem Versorgungsnetz zu erreichen, ist allgemein bekannt, siehe z.B. WO-A-8303011.

Der Erfindung liegt die Aufgabe zugrunde, eine Schaltung der eingangs genannten Art zu schaffen, mit der für ein drehstrombetriebenes Gerät mit einem Stromversorgungsnetzteil auf einfache Weise, d.h. mit möglichst wenig Aufwand unter Vermeidung obengenannter Nachteile ein Netztaktsignal auch bei Ausfall von einer oder zwei Phasen des Drehstromsystems erzeugt werden kann. Zur Lösung dieser Aufgabe sind ein Drehstromübertrager oder drei Einphasenübertrager vorgesehen, die zu einem Stromversorgungsnetzteil für das Gerät gehören und weiterhin sind zur 180°-Drehung einer von den drei Phasenspannungen des Drehstromsystems die Anschlüsse an der betreffenden Sekundärwicklung vertauscht. Zugleich sind die Phasenspannungen auf der Sekundärseite des Drehstromübertragers bzw. der Einphasenübertrager auf die Eingänge des Summierers geschaltet. Dies bedeutet, daß vorteilhafterweise die ohnehin für das Stromversorgungsnetzteil benötigten Übertrager zugleich auch für die Erzeugung eines Netztaktsignals verwendet werden. Zusätzliche Mittel zur Drehung der Phasenlage einer Spannung, z.B. ein Phasenschieber, werden bei dieser Lösung eingespart. Eine besonders einfache Ausführungsform für den Summierer ist gegeben, wenn dieser eine Sternpunktschaltung aus drei Widerständen, die auf der einen Seite an die drei Phasenspannungen angeschlossen sind und auf der anderen Seite einen gemeinsamen Sternpunkt bilden, sowie einen zusätzlichen Widerstand und einen dazu parallelgeschalteten Kondensator aufweist, die beide an den Sternpunkt geschaltet sind. Eine vorteilhafte Ausgestaltung besteht, wenn das Stromversorgungsnetzteil einen im Betrieb auf Bezugspotential liegenden Anschlußpunkt aufweist und wenn zwischen den Anschlußpunkt und den Sternpunkt der zusätzliche Widerstand geschaltet ist. Diese Schaltung kommt mit nur wenigen Elementen aus, die zudem sehr kostengünstig sind. Aus dem den Widerstand zwischen dem Anschlußpunkt und dem Sternpunkt durchfließenden Strom bzw. aus der an ihm abfallenden Spannung im Betrieb läßt sich das Netztaktsignal ableiten. Weiterhin ist es vorteilhaft, wenn die Sekundärwicklungen der Übertrager mit Gleichrichterbrücken des Stromversorgungsnetzteils verbunden sind, deren gemeinsamer Verbindungspunkt als auf Bezugspotential liegender Anschlußpunkt dient. Eine besonders einfache Ausgestaltung zur Erzeugung des Netztaktsignals liegt vor, wenn an den Sternpunkt ein Schwellwertschalter geschaltet ist, an dessen Ausgang das Taktsignal abgreifbar ist. Ist parallel zum zusätzlichen Widerstand eine Transistorschaltung als Schwellwertschalter angeschlossen, deren Transistor durch die Spannung am zusätzlichen (ohmschen) Widerstand ansteuerbar ist und an der das Taktsignal abgreifbar ist, so stellt dies eine besonders kostengünstige Ausgestaltung der Erfindung dar.

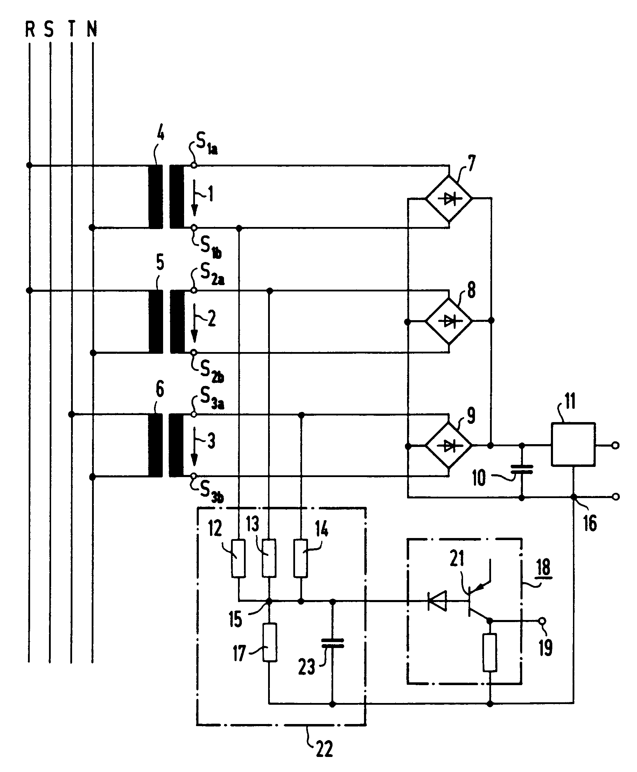

In der Zeichnung ist ein Ausführungsbeispiel der Erfindung dargestellt, das im folgenden näher beschrieben ist.

Sie zeigt ein Drehstromsystem R, S, T eines Verteilungsnetzes, an das ein Stromversorgungsnetzteil angeschlossen ist. Dieses besteht im wesentlichen aus drei einphasigen Übertragern 4, 5, 6, die an das Drehstromsystem R, S, T angeschlossen sind, drei parallelgeschalteten Gleichrichterbrücken 7, 8, 9, einem Glättungskondensator 10 und einem Spannungsregler 11. An den Sekundärwicklungen der Übertrager 4, 5, 6 mit den Anschlüssen S₁ₐ, S_{1b}, S₂ₐ, S_{2b}, S₃ₐ, S_{3b} liegen Phasenspannungen 1, 2, 3 an. Die Gleichrichterbrücken 7, 8, 9 sind an die Sekundärwicklungen der Übertrager 4, 5, 6 angeschlossen und richten im Betrieb die Phasenspannungen 1, 2, 3 gleich. Der anschließende Glättungskondensator 10 glättet die wellige Gleichspannung und speist den folgenden Spannungsregler 11. Der Verbindungspunkt 16 der Gleichrichterbrücken 7, 8, 9 dient als Anschlußpunkt mit Bezugspotential. Darüber hinaus ist in der Figur die Schaltung zur Erzeugung eines Netztaktsignals dargestellt, die mit den sekundärseitigen Phasenspannungen 1, 2, 3 betrieben wird. Die ohnehin für das Stromversorgungsnetzteil benötigten Übertrager 4, 5, 6 werden vorteilhafterweise auch zur Erzeugung des Netztaktsignals genutzt. Zur Netztaktschaltung gehören außerdem drei ohmsche Widerstände 12, 13, 14 in Sternschaltung mit gemeinsamem Sternpunkt 15. Die zweiten Anschlüsse der ohmschen Widerstände 12, 13, 14 sind jeweils mit einem Anschluß jeder Sekundärwicklung verbunden. Zum Anschluß der Phasenspannungen 2 bzw. 3 an die Widerstände 13 bzw. 14 sind dies die Anschlüsse S₂ₐ bzw. S₃ₐ, während die Phasenspannung 1 über den Anschluß S_{1b} an den Widerstand 12 angeschlossen ist. Durch die Vertauschung des Anschlusses der Phasenspannung 1 wird diese um 180° gedreht. In entsprechender Weise könnte natürlich auch eine der beiden anderen Phasenspannungen 2 oder 3 gedreht werden bei Beibehaltung der ursprünglichen Phasenlage für die beiden anderen Phasenspannungen. Zwischen dem Sternpunkt 15 und dem als Bezugspotential dienenden Anschlußpunkt des Stromversorgungsnetzteils liegt ein zusätzlicher ohmscher Widerstand 17.

Die Schaltung zur Erzeugung des Netztaktsignals funktioniert im wesentlichen in der Weise, daß z.B. durch die Hintereinanderschaltung der Widerstände 13 und 17 ein Strom in Phase mit der Spannung 2 fließt, der durch die Gleichrichterbrücke 8 gleichgerichtet ist. In den beiden anderen Hintereinander-schaltungen der ohmschen Widerstände 12 und 17 bzw. 14 und 17 fließen den Spannungen 1 bzw. 3 entsprechende Ströme, wobei allerdings die Phasendrehung der Phasenspannung 1 eine entsprechende Stromrichtungsumkehr zur Folge hat. Die drei Ströme in den als gleich groß angenommenen ohmschen Widerständen 12, 13, 14 sind etwa gleich groß, wobei der Strom durch den ohmschen Widerstand 12 in Phase ist zum Summenstrom aus den beiden Strömen durch die Widerstände 13 und 14 und auch im Betrag mit dem Summenstrom übereinstimmt. Näherungsweise addieren sich also die Ströme im zusätzlichen ohmschen Widerstand 17 zu einem Gesamtstrom, der doppelt so groß ist wie der durch den ohmschen Widerstand 12 hindurchfließende Strom. Die genannten Stromverhältnisse sind für den fehlerfreien symmetrischen Betrieb gültig. Aber auch bei Ausfall einer oder zweier Phasen fließt durch den Widerstand 17 ein Strom, der zur Erzeugung eines Netztaktsignals, z.B. durch Abgriff der an diesem Widerstand anliegenden Spannung genutzt werden kann. In der Zeichnung ist hierzu parallel zum zusätzlichen ohmschen Widerstand 17 eine Transistorschaltung 18 als Schwellwertschalter geschaltet, an deren Ausgang 19 das gewünschte Netztaktsignal abgreifbar ist. Der hier ebenfalls zum zusätzlichen ohmschen Widerstand 17 parallelgeschaltete Kondensator 23 dient zur Glättung und Entstörung. Die der Transistorschaltung 18 vorgeschaltete Diode soll einen Transistor 21 gegen Spannungsspitzen schützen. Anstelle der Transistorschaltung 18 kann als Schwellwertschalter ein Komparator eingesetzt werden.

## Patentansprüche

1. Schaltung zur Erzeugung eines aus der Netzfrequenz abgeleiteten Taktsignals für ein drehstrombetriebenes Gerät, bei der zwei Phasenspannungen eines angeschlossenen Drehstromsystems (1, 2, 3) unverändert um 120° gegeneinander phasenverschoben sind und die dritte Phasenspannung gegenüber ihrer ursprünglichen Phasenlage um 180° gedreht ist und bei der das Taktsignal am Ausgang eines Summierers (22) abgreifbar ist, **dadurch gekennzeichnet,** daß ein Drehstromübertrager oder drei Einphasenübertrager (4, 5, 6) vorgesehen sind, die zu einem Stromversorgungsnetzteil (7, 8, 9, 10, 11) für das Gerät gehören, daß zur 180°-Drehung einer von den drei Phasenspannungen des Drehstromsystems (1, 2, 3) die Anschlüsse an der betreffenden Sekundärwicklung vertauscht sind und daß die Phasenspannungen auf der Sekundärseite des Drehstromübertragers bzw. der Einphasenübertrager (4, 5, 6) auf die Eingänge des Summierers (22) geschaltet sind.

2. Schaltung nach Anspruch 1, **dadurch gekennzeichnet**, daß der Summierer (22) eine sternpunktschaltung aus drei widerständen (12, 13, 14), die auf der einen seite an die drei Phasenspannungen (1, 2, 3) angeschlossen sind und auf der anderen Seite einen gemeinsamen Sternpunkt (15) bilden, sowie einen zusätzlichen Widerstand (17) und einen dazu parallelgeschalteten Kondensator (23) aufweist, die beide an den sternpunkt (15) geschaltet sind.

3. Schaltung nach Anspruch 2, **dadurch gekennzeichnet**, daß das Stromversorgungsnetzteil einen im Betrieb auf Bezugspotential liegenden Anschlußpunkt (16) aufweist und daß zwischen dem Anschlußpunkt (16) und dem Sternpunkt (15) der zusätzliche Widerstand (17) geschaltet ist.

4. Schaltung nach Anspruch 3, **dadurch gekennzeichnet**, daß die Sekundärwicklungen der Einphasenübertrager (4, 5, 6) mit Gleichrichterbrücken (7, 8, 9) des Stromversorgungsnetzteils verbunden sind, deren gemeinsamer Verbindungspunkt als auf Bezugspotential liegender Anschlußpunkt (16) dient.

5. Schaltung nach Anspruch 3 oder 4, **dadurch** **gekennzeichnet,** daß an den Sternpunkt (15) ein Schwellwertschalter (18) geschaltet ist, an dessen Ausgang (19) das Taktsignal abgreifbar ist.

6. Schaltung nach Anspruch 3 oder 4, **dadurch gekennzeichnet,** daß parallel zum zusätzlichen Widerstand (17) eine Transistorschaltung als Schwellwertschalter (18) angeschlossen ist, deren Transistor (21) durch die Spannung an zusätzlichen Widerstand (17) ansteuerbar ist und an der das Taktsignal abgreifbar ist.

## Claims

1. Circuit for generating a clock signal derived from the power frequency for a rotary current-operated device, in which circuit two phase voltages of an attached rotary current system (1, 2, 3) are phase-shifted by 120° relative to each other, unaltered, and the third phase voltage is rotated by 180° relative to its original phase position, and in which the clock signal can be tapped from the output of a summing unit (22), characterised in that there is provided a rotary current transformer or three single-phase transformers (4, 5, 6) which belong to a power supply unit (7, 8, 9, 10, 11) for the device, in that, for the 180° rotation of one of the three phase voltages of the rotary current system (1, 2, 3), the terminals at the secondary winding concerned are exchanged, and in that the phase voltages on the secondary side of the rotary current transformer or the single-phase transformer (4, 5, 6) are connected to the inputs of the summing unit (22).

2. Circuit according to claim 1, characterised in that the summing unit (22) has a star connection comprising three resistors (12, 13, 14) which are connected on one side to the three phase voltages (1, 2, 3) and on the other side form a common star point (15), the summing unit (22) also having an additional resistor (17) and a capacitor (23) connected in parallel thereto, both of the latter being connected to the star point (15).

3. Circuit according to claim 2, characterised in that the power supply unit has a terminal (16) having a reference potential in operation, and in that the additional resistor (17) is connected between the terminal (16) and the star point (15).

4. Circuit according to claim 3, characterised in that the secondary windings of the single-phase transformer (4, 5, 6) are connected to rectifier bridges (7, 8, 9) of the power supply unit, the common connection point of which rectifier bridges (7, 8, 9) serves as a terminal (16) having a reference potential.

5. Circuit according to claim 3 or 4, characterised in that a trigger (18) is connected to the star point (15), from the output (19) of which trigger (18) the clock signal can be tapped.

6. Circuit according to claim 3 or 4, characterised in that a transistor circuit is connected as the trigger (18) in parallel to the additional resistor (17), the transistor (21) of which transistor circuit can be controlled by the voltage at the additional resistor (17) and from which the clock signal can be tapped.

## Revendications

1. Circuit pour produire un signal de cadence tiré de la fréquence du réseau pour un appareil alimenté en courant triphasé, et dans lequel deux tensions de phase d'un système triphasé raccordé (1, 2, 3) sont déphasées réciproquement de 120°, d'une manière non modifiée, et la troisième tension de phase est pivotée de 180° par rapport à sa position de phase initiale, et dans lequel le signal de cadence peut être prélevé sur la sortie d'un additionneur (22), caractérisé par le fait qu'il est prévu un transformateur triphasé ou trois transformateurs monophasés (4, 5, 6), qui font partie d'une partie du réseau d'alimentation en courant (7, 8, 9, 10, 11) pour l'appareil, que pour la rotation de 180° de l'une des trois tensions de phase du système triphasé (1, 2, 3), les bornes sont permutées au niveau de l'enroulement secondaire considéré et que les tensions de phase sur le côté secondaire du transformateur triphasé ou des transformateurs monophasés (4, 5, 6) sont appliquées aux entrées de l'additionneur (22).

2. Circuit selon la revendication 1, caractérisé par le fait que l'additionneur (22) possède un circuit à neutre constitué par trois résistances (12, 13, 14), qui sont raccordées d'un côté aux trois tensions de phase (1, 2, 3) et forment, d'un autre côté, un neutre commun (15), ainsi qu'une résistance supplémentaire (17) et un condensateur (23) branché en parallèle avec cette résistance, ces deux éléments étant raccordés au neutre (15).

3. Circuit suivant la revendication 2, caractérisé par le fait que la partie du réseau d'alimentation en courant possède un point de raccordement (16) qui en fonctionnement est placé au potentiel de référence et que la résistance supplémentaire (17) est branchée entre le point de raccordement (16) et le neutre (15).

4. Circuit suivant la revendication 3, caractérisé par le fait que les enroulements secondaires des transformateurs monophasés (4, 5, 6) sont raccordés à des ponts redresseurs (7, 8, 9) de la partie du réseau d'alimentation en courant, dont le point de jonction commun est utilisé comme point de raccordement (16) placé au potentiel de référence.

5. Circuit suivant la revendication 3 ou 4, caractérisé par le fait qu'au neutre (15) est raccordé un commutateur à valeur de seuil (18), sur la sortie (19) duquel peut être prélevé le signal de cadence.

6. Circcuit suivant la revendication 3 ou 4, caractérisé par le fait qu'en parallèle à la résistance supplémentaire (17) est raccordé un circuit à transistor constitué sous la forme d'un commutateur à valeur de seuil, dont le transistor (21) peut être commandé par la tension aux bornes de la résistance supplémentaire (17) et au niveau duquel peut être prélevé le signal de cadence.
